# EUROPEAN PATENT APPLICATION

(11) **EP 2 560 195 A1**
(43) Date of publication of application: **20.02.2013**
(21) Application number: 11177878.3
(22) Date of filing: 17.08.2011
(51) Int. Cl.: H01L 21/28, H01L 21/336, H01L 27/108, G11C 11/404, G11C 16/04, H01L 29/423, H01L 29/788, H01L 29/68

(54) **Memory device with an isolated gate comprising two portions separated by a barrier and method of operating the same**

(71) Applicant: Hitachi Ltd., Tokyo (JP)
(72) Inventor: Williams, David, Cambridge, Cambridgeshire CB3 0HE (GB)
(74) Representative: Piotrowicz, Pawel Jan Andrzej

(57) **Abstract**

A memory device is described. The memory device comprises a semiconductor channel (4), a control gate (11) and an isolated gate (7). The isolated gate comprises first and second portions (8₁,8₂) separated by a barrier (9) region, the first gate portion arranged proximate to the channel to control conductivity of the channel and the second portion arranged proximate to the control electrode. The isolated gate comprises non-ferroelectric material, such as silicon. The isolated gate is configured to be polarizable in response to an applied external electric field generated using the control gate, without injection of charge carriers to or from the channel, and to remain polarized for a given non-zero time after the electric field is removed.

## Description

The present invention relates to a memory device. In particular, the present invention relates to a volatile memory device.

Dynamic random access memory (DRAM) is a volatile form of memory which requires periodic refreshing in order to store data. DRAM is used in main memory in computing devices and can provide high storage densities. An introduction to DRAM can be found in Chapter 5 of "Semiconductor memories" by B. Prince, 2nd ed., John Wiley (1991).

DRAM is usually provided as an array of cells addressed by a set of word and bit lines. In its simplest form, a DRAM cell comprises a single storage capacitor and a single transistor. This form of cell is commonly referred to as a "1T DRAM cell".

A 1T DRAM cell can be programmed with a '1' by driving the bit line high and selecting the word line so as to charge the storage capacitor. Data is read by precharging the bit line to an intermediate voltage level, selecting the word line and detecting the change in bit line voltage using a remote sense amplifier.

Although DRAM is widely used, it suffers the drawback that the capacitor should ideally be as large as possible so as to maximise the change in voltage. This can be achieved by fabricating the storage capacitor in a deep trench or as a crown and/or by using high-k dielectric materials. These structures and materials generally make DRAM cells more difficult to integrate into other forms of circuit such as a complementary metal-oxide-semiconductor (CMOS) logic circuit or at least require additional fabrication stages.

The present invention seeks to provide an improved memory device, for example, which can serve as volatile memory and which can be incorporated more easily into other forms of circuit.

According to a first aspect of the present invention there is provided a memory device comprising a semiconductor channel, a control gate and an isolated gate comprising first and second portions separated by a barrier region, the first gate portion arranged proximate to the channel to control conductivity of the channel and the second portion arranged proximate to the control electrode, the isolated gate comprising non-ferroelectric material, wherein the isolated gate is configured to be polarizable in response to an applied external electric field generated using the control gate, without injection of charge carriers to or from the channel, and to remain polarized for a given non-zero time after the electric field is removed.

Thus, charge on the isolated gate can locally control current flowing through the channel, for example similar to a Flash memory device, and the device can also be easily fabricated, for example in a similar way to a MOSFET. However, unlike a Flash memory device, during normal operation, no charge carriers are injected into or out of the isolated gate from the channel (or contacts to the channel) or the control gate.

The barrier region may be configured to provide a tunnel barrier between the first and second portions of the isolated gate. Thus, the isolated gate can be polarized by a charge tunnelling which can help to prolong retention time.

The barrier region may comprise a semiconductor, for example, silicon. This can help to simplify fabrication. The barrier region may comprise a dielectric. This can help to provide a barrier having a high breakdown voltage, for example, greater than 1 MVcm⁻¹.

The first and second portions of the isolated gate may comprise a semiconductor material, such as silicon. Thus, the device can fabricated using widely-adopted fabrication processes. The first and/or second portions of the isolated gate may comprise monocrystalline semiconductor material, polycrystalline semiconductor material or amorphous semiconductor material. The first and/or second portions of the isolated gate may be lightly doped (for example, less than 10¹⁸cm⁻³) or heavily doped (for example, more than 10¹⁸cm⁻³).

The memory device may comprise a gate dielectric interposed between the first portion of the isolated gate and the channel. The gate dielectric may comprise silicon dioxide.

The first and second portions of the isolated gate may be spaced apart in a first direction and the first portion of the isolated gate and the channel may be spaced apart in a second direction substantially perpendicular to the first direction. The first and second portions of the isolated gate may be spaced apart in a first direction and the channel may run in a direction between first and second contact regions which is substantially perpendicular to the first direction. The first and second portions of the isolated gate may be spaced apart in a first direction and the channel may run in a direction between first and second contact regions which is substantially parallel to the first direction.

According to a second aspect of the present invention there is provided an array of memory devices and a set of lines for addressing the memory devices.

According to a third aspect of the present invention there is provided a logic circuit, for example a CMOS logic circuit, comprising at least one memory device.

According to a fourth aspect of the present invention there is provided a method of operating the memory device, the method comprising polarizing the isolated gate at a given time, reading the memory device; and refreshing the memory device by polarizing the isolated gate within 500 ms of the given time.

Refreshing the memory device may comprise polarizing the isolated gate within 100 or 200 ms of the given time.

Certain embodiments of the present invention will now be described, by way of example, with reference to the accompanying drawings, in which:
Figure 1 is a plan view of a first memory device in accordance with the present invention;
Figure 1a is a cross-sectional view of the memory device shown in Figure 1 taken along the line A-A';
Figure 1b is a cross-sectional view of the memory device shown in Figure 1 taken along the line B―B';
Figures 2a and 2b show two states of an isolated gate of the memory device shown in Figure 1;
Figure 3 is a schematic circuit diagram of the memory device shown in Figure 1;
Figure 4 is a schematic diagram of memory including an array of memory devices;
Figure 5 illustrates writing data to the memory device shown in Figure 1;
Figure 6 illustrates reading data from the memory device shown in Figure 1;
Figure 7 is a process flow diagram of a method of fabricating the first memory device;
Figures 8a to 8g illustrate fabrication of the device shown in Figure 1 at different stages during fabrication;
Figures 9a to 9g illustrate fabrication of the device shown in Figure 1 at different stages during fabrication;
Figure 10 is a plan view of a second memory device in accordance with the present invention;
Figure 10a is a cross-sectional view of the memory device shown in Figure 10 taken along the line C-C';
Figure 11a is a plan view of a first alternative isolated gate configuration;
Figure 11b is a cross-sectional view of the first alternative isolated gate configuration shown in Figure 11a taken along the line D-D';
Figure 12a is a plan view of a second alternative isolated gate configuration;
Figure 12b is a cross-sectional view of the second alternative isolated gate configuration shown in Figure 12a taken along the line E-E';
Figure 13a is a plan view of a third alternative isolated gate configuration;
Figure 13b is a cross-sectional view of the third alternative isolated gate configuration shown in Figure 13a taken along the line F-F';
Figure 14 is a plan view of a third memory device; and
Figure 14a is a cross-sectional view of the memory device shown in Figure 14 taken along the line G-G'.

### First memory device - layout

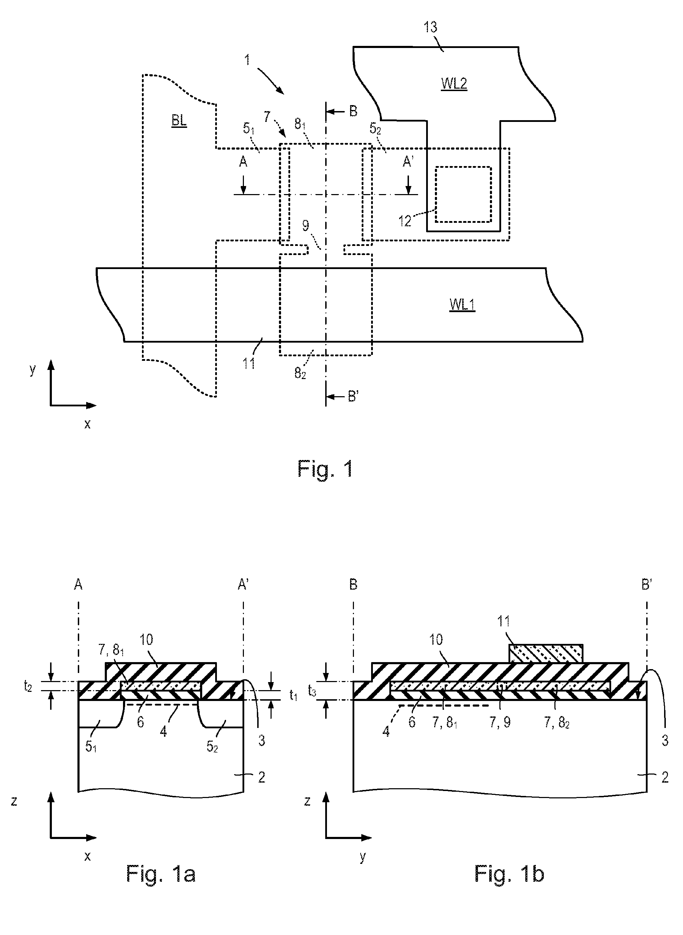

Referring to Figures 1, 1a and 1b, a first memory device 1 in accordance with the present invention is shown. The memory device 1 can operate as volatile memory.

The memory device 1 is provided on a semiconductor substrate 2 having a principal surface 3 (hereinafter also referred to as an "upper" or "top" surface 3). A channel 4 is formed at the upper surface 3 of the substrate 4 between first and second doped wells 5₁, 5₂ providing respective first and second contact regions (usually referred to as "source" and "drain" regions).

In this example, the semiconductor substrate 2 is p-type and the first and second contact regions 5₁, 5₂ are n-type. However, the semiconductor substrate 2 may be n-type and the first and second contact regions 5₁, 5₂ may be p-type. The semiconductor substrate 2 and the contact regions may share the same conductivity type (e.g. p-type), i.e. the contact regions 5₁, 5₂ may be formed in a large doped well formed in the substrate, the contact regions and substrate being of opposite conductivity type to the large doped well.

A gate dielectric 6 overlies a portion of the upper surface 3 of the substrate 4 and separates an isolated gate 7 from the substrate 2. In this example, the gate dielectric 6 and isolated gate 7 are substantially co-extensive.

As will be explained in more detail later, the gate dielectric 6 is sufficiently thick to prevent charge carriers in the channel 4 or contact regions 5₁, 5₂ from being injected into the isolated gate 7 and *vice versa.* In this example, the gate dielectric 6 comprises silicon dioxide (SiO₂) and preferably has a thickness, t₁, of at least 200 Å, preferably at least 400 Å.

The isolated gate 7 comprises first and second conductive regions 8₁, 8₂ separated by a barrier region 9. The isolated gate 7 comprises non-ferroelectric material(s) and the conductive regions 8₁, 8₂ of the isolated gate 7 preferably comprise a semiconductor material and more preferably comprise silicon.

In this example, the conductive regions 8₁, 8₂ and the barrier region 9 are formed in a layer of semiconductor material having a thickness, t₂. In this example, the semiconductor material is lightly-doped, n-type polycrystalline silicon having a thickness, t₂, of about 1000 Å. The conductive regions 8₁, 8₂ comprise relatively wide and long regions (herein referred to as "lobes") of semiconductor material and the barrier region 9 comprises a relatively narrow and short region (herein referred to as a "waist") of semiconductor material which is depleted. As will be explained in more detail later, the isolated gate 7 can be differently configured and need not comprise the same material. For example, the barrier region 9 can be provided by a n-p-n (or p-n-p) junction in semiconductor material or may be provided by a region of dielectric material, such as silicon dioxide or silicon nitride.

The first conductive region 8₁ is proximate to the channel 4 and is used to control conductivity of the channel 4. Thus, the channel 4 is can be used to detect charge of the first conductive region 8₁. Therefore, the first conductive region 8₁ is herein referred to as the "sensed node" or simply "node".

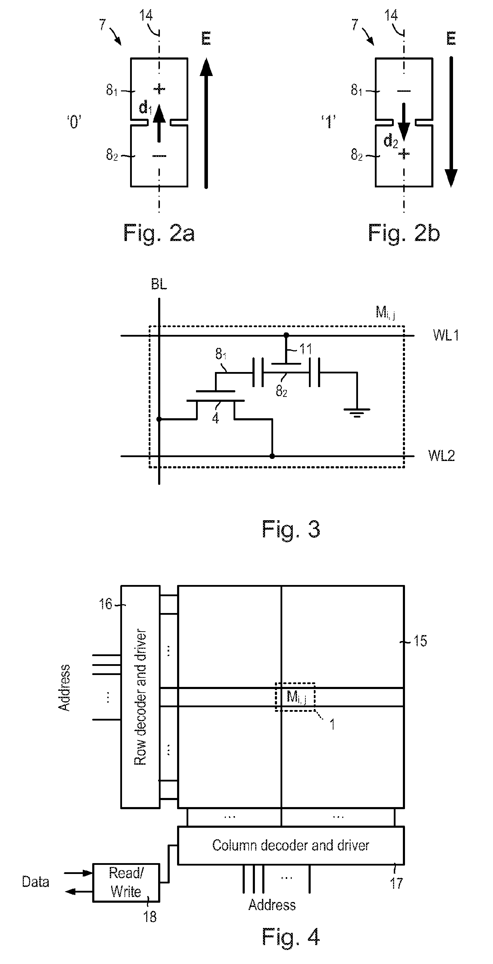

Referring also to Figures 2a and 2b, the isolated gate 7 has an axis 14 along which it can be polarized in parallel or anti-parallel directions corresponding to, for example, '0' and '1' logical states respectively. Depending on the direction of polarization, the polarity of the node 8₁, i.e. first conductive region 8₁, can be negative or positive. The polarity of the node 8₁ is detected measuring the current flowing through the channel 4.

Referring still to Figures 1, 1a and 1b and also to Figure 3, the isolated gate 7 is covered by a thick layer of dielectric material 10 having a thickness, t₃. In this example, the dielectric material is silicon dioxide (SiO₂) and has a thickness, t₃, of at least 500 Å, preferably between about 1000 Å and 2000 Å. The dielectric layer 10 separates the second portion 8₂ of the isolated gate 7 from a control gate 11. The control gate 11 comprises highly-doped, n-type polycrystalline silicon, for example, having a thickness of at least 1000 Å.

As shown in Figure 1, the control gate 11 is part of a conductive track or line which can be used to address a row of memory devices 1 and is herein referred to a "first word line" or "WL1".

The dielectric layer 10 has a via 12 which allows an electrode 13 to contact the underlying second contact region 5₂. The electrode 13 comprises highly-doped, n-type polycrystalline silicon. The electrode 13 is part of a conductive track or line, herein referred to as a "second word line" or "WL2".

The first contact region 5₁ is part of a conductive track and is herein referred to as a "bit line" or "BL". The bit line is formed as a diffusion line in the substrate 2.

Referring to Figure 4, memory is shown which comprises an array 15 of memory devices 1, each corresponding to a memory cell M_{i,j}, controlled and accessed by row and column decoders 16, 17 and a read/write buffer 18.

### First memory device - device operation

Referring to Figures 1, 1a and 1b, operation of the memory device 1 is based on polarizing the isolated gate 7 and measuring the charge on the sensed node 8₁. During operation, no charge carriers are injected into or out of the isolated gate 7 (for example, by direct tunnelling, by Fowler Nordheim tunnelling or by hot-electron injection) from the channel 4, the contacts 5₁, 5₂ or the control gate 11. For example, applying fields of 1MV/cm, 2MV/cm or 5 MV/cm may result in substantially no charge carriers being injected. In some embodiments, applying even higher fields, for example 10 MV/cm, may still result in substantially no charge carriers being injected. Thus, polarization results from redistribution of charge on the isolated gate 7.

In this example, the barrier region 9 prevents charge carriers being transferred between the first and second portions 8₁, 8₂ of the isolated gate 7. However, the barrier region 9 may be configured to be sufficiently narrow and/or of low barrier height to allow charge carriers to be transferred between the first and second portions 8₁, 8₂ of the isolated gate 7, for example, by direct tunnelling or Fowler Nordheim tunnelling.

Referring in particular to Figures 2a and 2b, the memory device 1operates by the isolated gate 7 being polarized by an external electric field, E. The isolated gate 7 takes time to relax back to its original, un-polarized state after the external electric field, E, has been removed. The isolated gate 7 remains polarized for a given non-zero time, t, typically having an order of magnitude of about 0.1 s or 1s. Given the short retention time, the memory device 1 is not intended to be used as a non-volatile memory. However, if the retention time is significantly longer (for example, at least about 10 years), then the memory device 1 can be used as non-volatile memory.

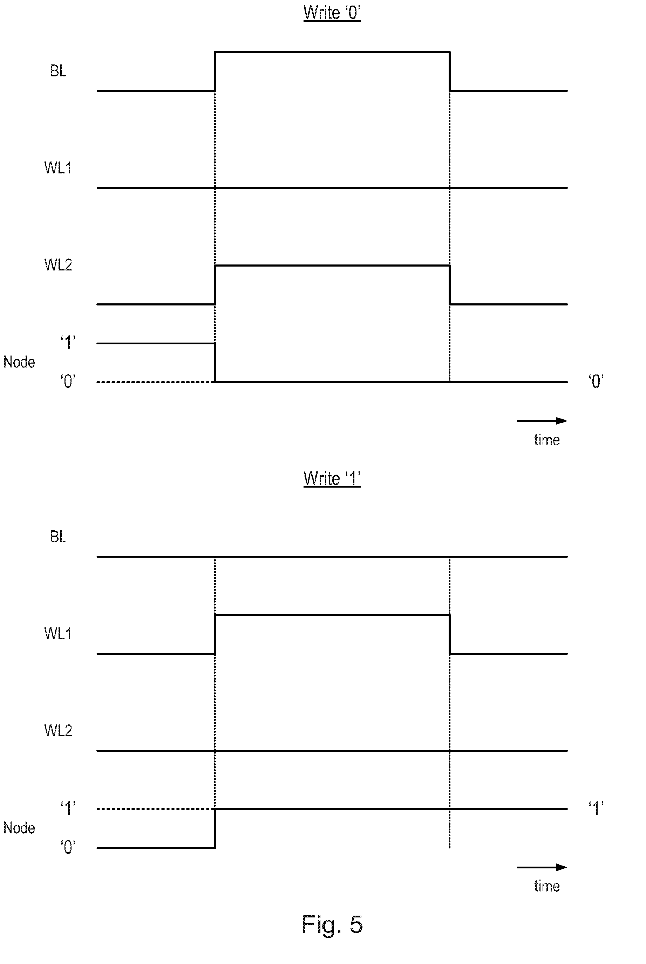

Writing data to the memory device 1 will now be described with reference to Figures 1, 2a, 2b and 5.

The isolated gate 7 is polarized by applying an electric field, E, parallel or anti-parallel to the axis 14 (herein referred to as the "axis of polarization") running through the first and second portions 8₁, 8₂ and the barrier region 9.

To program the memory device 1 with a '0', high positive biases are applied to the bit line (i.e. the first contact region 5₁) and the second word line (i.e. the second contact region 5₂) while the first word line (i.e. the control gate 10) is held at 0V or at a large negative bias. Typically, a large bias is at least 5V, preferably at least 10V and, more preferably, at least 20V and is preferably less than 20V.

If the isolated gate 7 is already in the state '0' (shown in chain), then the '0' write operation refreshes the '0' state. If, however, the isolated gate 7 is in the state '1', then the '0' write operation causes the polarization of the isolated gate 7 to reverse polarization.

To program the memory device 1 with a '1', a high positive bias is applied to the first word line (i.e. to the control gate 10) while the bit line (i.e. to the first contact region 5₁) and the second word line (i.e. the second contact region 5₂) are at 0V or at a large negative bias.

If the isolated gate 7 is already in the state '1' (shown in chain), then '1' write operation refreshes the state. If, however, the isolated gate 7 is in the state '0', then the operation causes the polarization of the isolated gate 7 to reverse polarization.

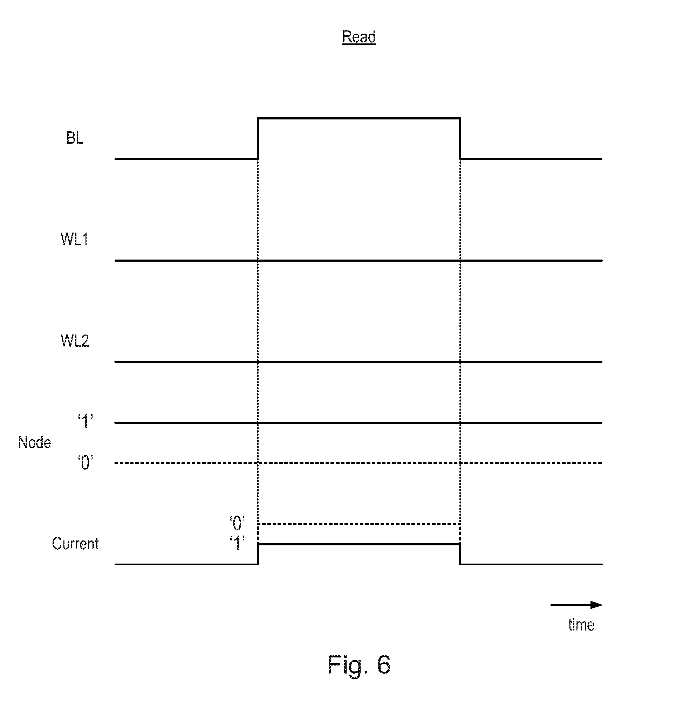

Reading data from the memory device 1 will now be described with reference to Figures 1, 2a, 2b and 6.

The sensed node 8₁ (i.e. the first portion 8₁ of the isolated gate 7) is read by allowing the first word line (i.e. the control gate 10) to float and applying a large bias to the bit line (i.e. the first contact region 5₁) while the second word line (i.e. the second contact region 5₂) is held low. The current flowing through the bit line depends on whether the node 8₁ is positively or negatively charged.

After a read operation has been performed, the memory device 1 can be refreshed by re-writing data to the device 1.

The memory device 1 can be used as an alternative to conventional DRAM memory. However, due to the fact that the device does not need complex trench or crown structures, it is possible to use the device 1 as a volatile memory structure in a wider variety of circuits, in particular those in which DRAM memory is not widely used, such as CMOS circuits.

In the example given above, the states of the device are defined by parallel and anti-parallel polarizations. However, in some embodiments, one of the states may be defined by zero polarization. Moreover, in other embodiments, the states may be polarized in the same direction, but may have different magnitudes (i.e. defined by different amounts of induced charge).

### First memory device - device fabrication

The memory device 1 can be fabricated in a similar way to a metal-oxide-semiconductor field-effect transistor (MOSFET). A method of fabricating the memory device 1 will now be described with reference to Figures 1, 7, 8a to 8g and 9a to 9g.

Referring in particular to Figures 1, 7, 8a and 9a, the memory device 1 is formed on a semiconductor wafer 2' having an upper surface 3. In this example, the semiconductor wafer 2' is a p-type silicon wafer.

Active areas (not shown) of a semiconductor wafer may be defined by trench isolation or formation of dielectric isolation regions (step S7-1). The isolation regions (not shown) take the form of regions of field oxide (not shown) fabricated using a LOCOS process.

Diffusion wells (not shown) may be defined for forming PMOS devices, for example, to allow formation of CMOS circuits. However, for simplicity, the formation of nested diffusion wells is not described in detail here.

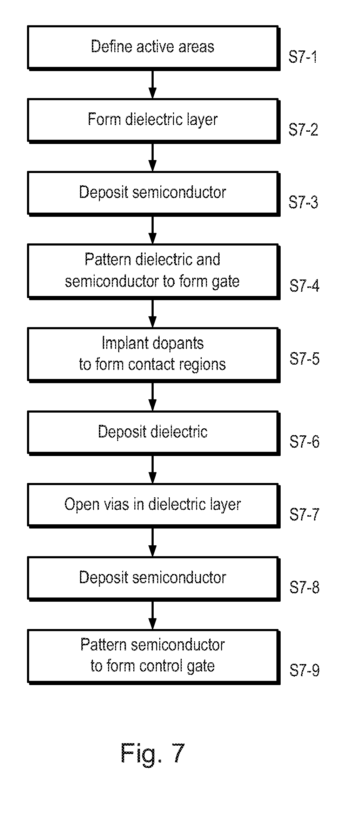

Referring in particular to Figures 7, 8a and 9a, a layer 6' of dielectric material is formed on the surface 3 of the wafer 2' by deposition or sacrificially converting semiconductor material (step S7-2). In this example, a layer 6' of silicon dioxide(SiO₂) is grown by thermal oxidation.

Referring still to Figures 7, 8b and 9b, a layer 7' of semiconductor material is deposited directly on the surface 21 of the dielectric layer 6' (step S7-3).

In this example, a layer 7' of polycrystalline silicon is deposited by a chemical vapour deposition (CVD) process, such as low-pressure CVD (LPCVD).

A layer (not shown) of resist is applied to the surface 22 of the semiconductor layer 7' and patterned using a lithography process capable of defining sub-micron feature sizes. An electron-beam, X-ray or high-resolution optical lithography can be used. The resist (not shown) is patterned to form a mask (not shown) to protect regions 23, 24 of the layers 6', 7' from a subsequent etching process.

Unmasked regions 25, 26 of the layers 6', 7' are etched using reactive ion etching using suitable feed gases (step S7-4).

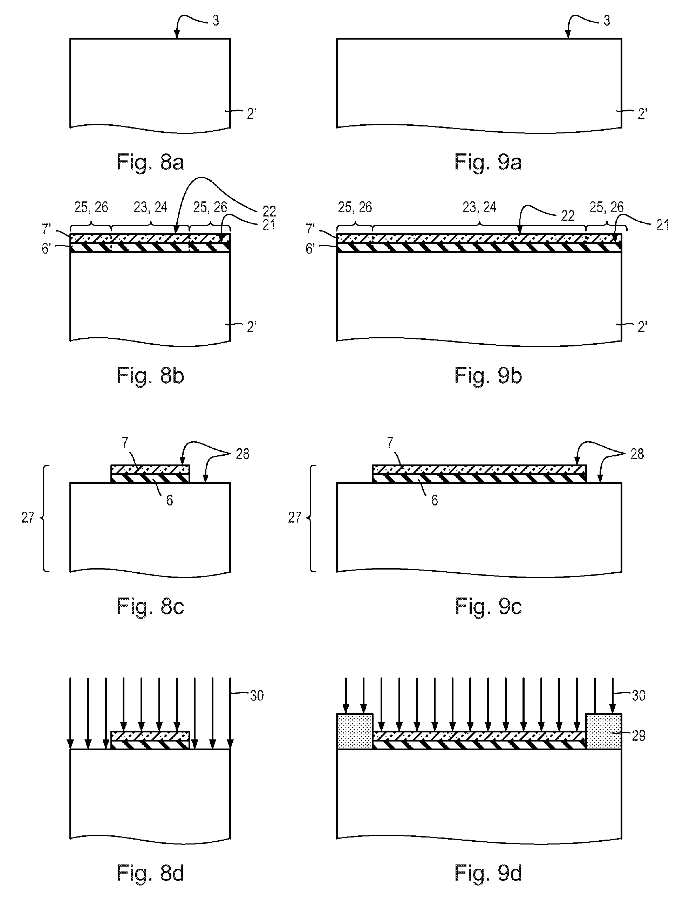

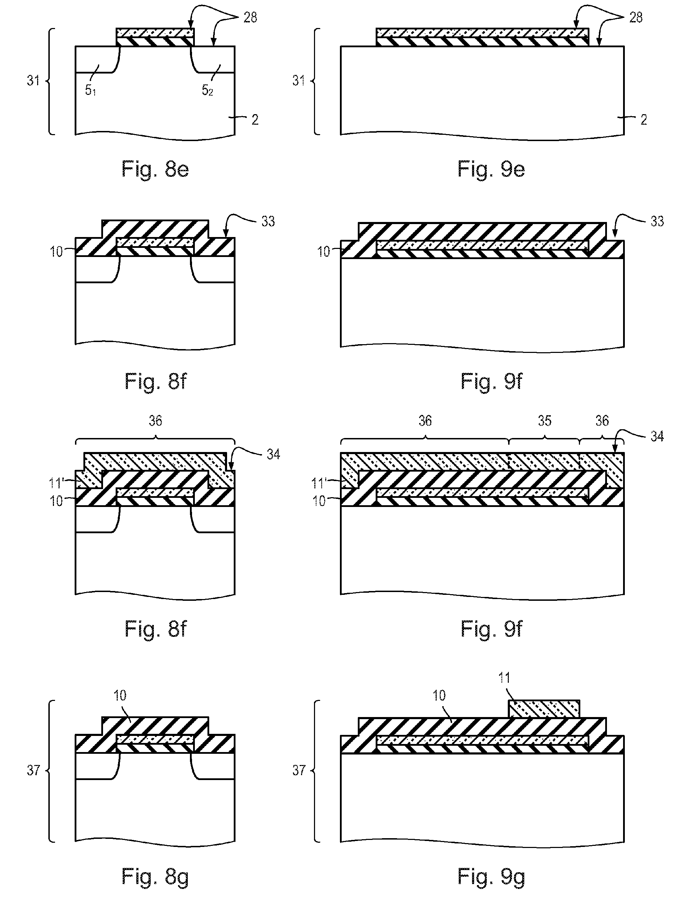

Figures 8c and 9c show the resulting structure 27 having a surface 28 which includes co-extensive regions of dielectric layer 6 and semiconductor layer 7 that provide the gate dielectric 6 and isolated gate 7 respectively.

The etch mask is removed and a layer (not shown) of resist is applied to the surface 28 of the structure 27 and patterned using a lithography process. By removing the etch mask, dopants can be implanted into the isolated gate 7. However, if an undoped isolated gate 7 is required or a different doping profile or pattern is needed, then the etch mask can be kept in place to protect the isolated gate.

Referring to Figures 7, 8d and 9d, the resulting patterned resist layer 29 is used as a mask for implantation of high-energy (>10 keV) dopants 30, such as arsenic (As) (step S7-5).

The resist layer 29 is removed and the structure is annealed is activate the implant.

Figures 8e and 9f show the resulting structure 31 which includes first and second contacts 5₁, 5₂ in the substrate 2 which are self aligned with the gate dielectric 6 and isolated gate 7.

Referring also to Figures 7, 8f and 9f, a layer 10 of dielectric material having an upper surface 33 is formed on the surface 28 of the structure 31 by deposition (step S7-6). In this example, a layer 11 of silicon dioxide (SiO₂) is deposited by CVD, for example, LPCVD.

A layer (not shown) of resist is applied to the surface 33 of layer 10 and patterned using a lithography process to form an etch mask. A via 12 (Figure 1) is etched through the layer 10 using reactive ion etching using suitable feed gases (step S7-7)

Referring to Figures 7, 8f and 9f, a layer 11' of semiconductor material is deposited on the surface 33 of the dielectric layer 10 (step S7-8). In this example, a layer 11' of polycrystalline silicon is deposited by CVD, such as LPCVD. However, metal(s) can be used and can be deposited using a physical deposition process, such as sputtering.

A layer (not shown) of resist is applied to the surface 34 of the semiconductor layer 11' and patterned using a lithography process. The resist is patterned to form a mask (not shown) to protect regions 35 of the semiconductor layer 11'.

Unmasked regions 36 of the semiconductor layer 11' are etched using reactive ion etching using suitable feed gases (step S7-9).

Figures 8g and 9g show the resulting structure 37 which includes the control gate 11 lying on the dielectric layer 10.

Further processing steps can be carried, such as depositing and patterning additional dielectric and conductive layer, to form bond pads and other structures.

### Second memory device - layout

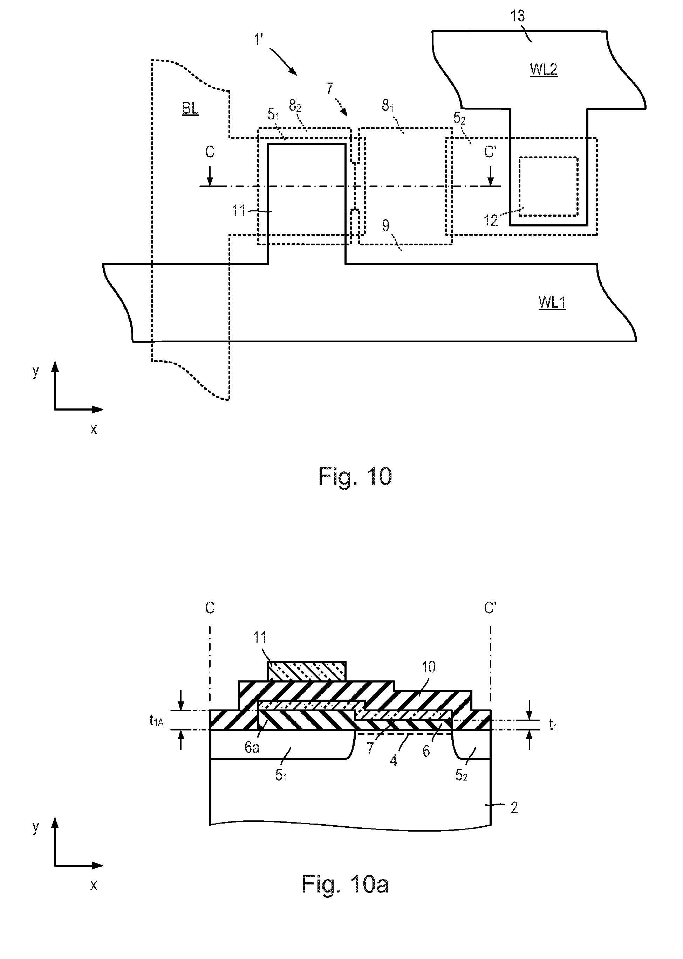

Referring again to Figures 1, 1a and 1b, in the first memory device 1, the isolated gate 7 is arranged such that the first conductive region 8₁ is positioned over the channel 4 and the second conductive region 8₂ is not located over the channel 4. This is achieved by orientating the isolated gate 7 perpendicular to the channel 4. Referring to Figures 10 and 10a, a second memory device 1' in accordance with the present invention is shown.

The second memory device 1' is similar to first memory device 1 (Figure 1) and like parts are denoted by like reference numerals.

In the second memory device 1, the second conductive region 8₂ is formed over the first contact region 5₁. This is achieved by orientating the isolated gate 7 parallel to the channel 4.

To provide an electric field directed along the isolated gate 7, a thicker gate dielectric 6a is provided between the second conductive region 8₂ and the substrate 2. The thicker gate dielectric 6a has a thickness, t_{1A}, where, for example, t_{1A} ≥ 2.t₁.

The second device 1' requires additional fabrication stages not shown in Figure 7. For example, a self-aligned process for forming the first and second contact regions 5₁, 5₂ is not possible and so fabrication requires an additional mask step to define the implanted regions. The stepped gate dielectric 6, 6a also requires an additional step, e.g. to define a window for etching back a thick dielectric layer to form a thinner dielectric layer 6.

The second memory device 1' is operated in the same or at least in a similar way to the first memory device 1 (Figure 1) described earlier. Therefore, operation of the second memory device 1' is not repeated here.

### Alternative isolated gate configurations

In the embodiments hereinbefore described, a barrier region is provided by a depletion region in a semiconductor. By configuring the geometry and dimensions of the isolated gate for a given doping density, the width and height of the barrier can be adapted.

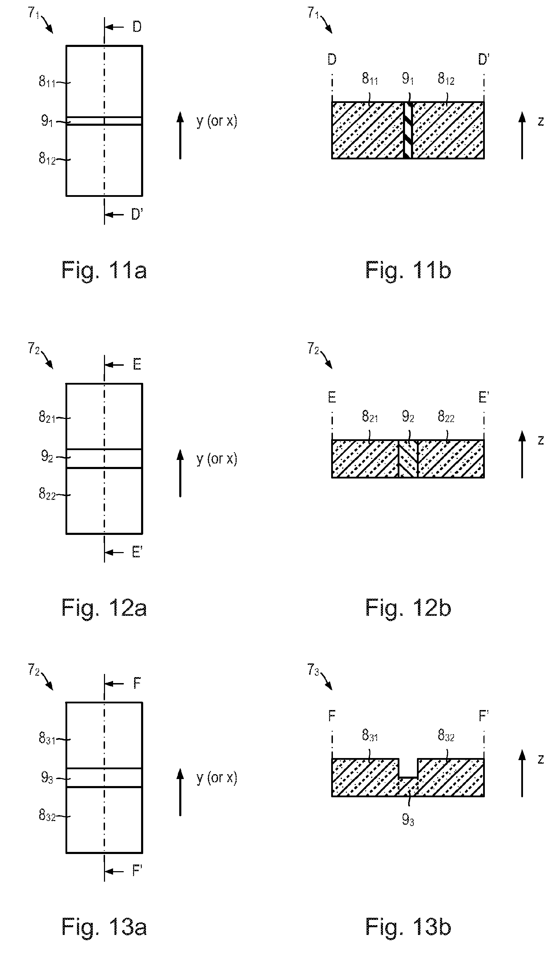

Referring to Figures 11a, 11b, 12a, 12b, 13a and 13b, other examples of isolated gates and tunnel region arrangements will now be described

Referring in particular to Figures 11a and 11b, an isolated gate 7₁ is shown comprising first and second conductive regions 8₁₁, 8₁₂ and a barrier region 9₁.

The first and second conductive regions 8₁₁, 8₁₂ comprise respective regions of semiconductor material, for example, the same semiconductor material. The semiconductor material may be silicon. The semiconductor material may be moncrystalline, polycrystalline or amorphous. The semiconductor material may be undoped (for example, less than 10¹⁶cm⁻³), lightly doped (for example, less than 10¹⁸cm⁻³) or heavily doped (for example, more than 10¹⁸cm⁻³). Doping may be n-type or p-type. The first and second conductive regions 8₁₁, 8₁₂ may be doped differently (for example, one n-type and the other p-type) and /or can have different doping concentrations.

Typically, the first and second conductive regions 8₁₁, 8₁₂ have a width/length, diameter or other lateral dimension having an order of magnitude of 1 nm, 10 or 100 nm, for example having dimension(s) between about 20 and 100 nm.

The thickness of the conductive regions 8₁₁, 8₁₂ may have an order of magnitude of 1 nm, 10 or 100 nm, for example a thickness between about 20 and 100 nm.

The first and second conductive regions 8₁₁, 8₁₂ may have the same dimensions. However, the conductive regions 8₁₁, 8₁₂ may have different sizes, e.g. width, length and/or thickness and/or may have different layouts.

The barrier region 9₁ comprises a region of dielectric material, such as silicon dioxide, silicon nitride, silicon oxynitride or some other dielectric. The barrier region 9₁ may be formed by the dielectric layer 10 (Figure 1).

Typically, the barrier region 9₁ has a length (i.e. the dimension separates the conductive regions) having an order of magnitude of 1 nm or 10 nm, for example having a length of between about 4 and 10 nm.

The barrier region 9₁ may be formed by depositing one conductive region, forming dielectric material by sacrificially converting a surface region of the conductive region (by oxidation or nitridation) and/or my depositing a dielectric material, and depositing the other conductive region.

Referring in particular to Figures 12a and 12b, an isolated gate 7₂ is shown comprising first and second conductive regions 8₂₁, 8₂₂ and a barrier region 9₂.

The first and second conductive regions 8₂₁, 8₂₂ comprise respective regions of semiconductor material, for example, the same semiconductor material. The semiconductor material may be silicon. The semiconductor material may be moncrystalline, polycrystalline or amorphous. The semiconductor material may be undoped (for example, less than 10¹⁶cm⁻³), lightly doped (for example, less than 10¹⁸cm⁻³) or heavily doped (for example, more than 10¹⁸cm⁻³). Doping may be n-type or p-type. The first and second conductive regions 8₂₁, 8₂₂ may be doped differently (for example, one n-type and the other p-type) and /or can have different doping concentrations.

Typically, the first and second conductive regions 8₂₁, 8₂₂ have a width/length, diameter or other lateral dimension having an order of magnitude of about 1 nm, 10 or 100 nm, for example having dimension(s) between about 20 and 100 nm.

The thickness of the conductive regions 8₂₁, 8₂₂ may have an order of magnitude of 1 nm, 10 or 100 nm, for example a thickness between about 20 and 100 nm.

The first and second conductive regions 8₂₁, 8₂₂ may have the same dimensions. However, the conductive regions 8₂₁, 8₂₂ may have different sizes, e.g. width, length and/or thickness and/or may have different layouts.

The barrier region 9₂ comprises a region of semiconductor material, such as silicon, and may form a homostructure or a heterostructure with the conductive regions 8₂₁, 8₂₂.

Typically, the barrier region 9₂ has a length (i.e. the dimension that separates the conductive regions) having an order of magnitude of 1 nm or 10 nm, for example having a length of between about 4 and 10 nm.

In the case of a homostructure, the barrier region 9₂ comprises the same material as one or both of the conductive regions 8₂₁, 8₂₂, but is doped with a dopant of opposite conductivity type. Thus, an n-p-n or p-n-p structure may be formed.

An n-p-n or p-n-p structure can be formed by depositing a layer of semiconductor material, which may be doped with a dopant of particular conductivity type (e.g. n-type) *in-situ* during deposition, forming a mask exposing the intended barrier region (or conductive regions ) and implanting dopants of opposite conductivity type (e.g. p-type).

In the case of a heterostructure, the barrier region 9₂ comprises a material having a larger band gap than the material forming the conductive regions 8₂₁, 8₂₂. For example, the heterostructure can comprise GaAs/AlAs/GaAs or GaAs/ AlₓGa₍₁₋ₓ₎As / GaAs structure, other similar form of binary alloy /ternary alloy /binary alloy structure.

A heterostructure can be formed using an epitaxial overgrowth process.

Referring in particular to Figures 13a and 13b, an isolated gate 7₃ is shown comprising first and second conductive regions 8₃₁, 8₃₂ and a barrier region 9₃.

The first and second conductive regions 8₃₁, 8₃₂ and a barrier region 9₃ may comprise respective regions of semiconductor material, for example, the same semiconductor material. The semiconductor material may be silicon. The semiconductor material may be moncrystalline, polycrystalline or amorphous. The semiconductor material may be undoped (for example, less than 10¹⁶cm⁻³), lightly doped (for example, less than 10¹⁸cm⁻³) or heavily doped (for example, more than 10¹⁸cm⁻³) . Doping may be n-type or p-type. The first and second conductive regions 8₃₁, 8₃₂ and barrier region 9₃ may be doped differently (for example, one n-type and the other p-type) and /or can have different doping concentrations.

Typically, the first and second conductive regions 8₃₁, 8₃₂ have a width/length, diameter or other lateral dimension having an order of magnitude of about 1 nm, 10 or 100 nm, for example having dimension(s) between about 20 and 100 nm.

The thickness of the conductive regions 8₃₁, 8₃₂ may have an order of magnitude of about 1 nm, 10 or 100 nm, for example a thickness between about 20 and 100 nm.

A combination or two or more of these arrangements (including the arrangement shown in Figure1) can be used. For example, a barrier region may be formed by a combination of lateral and vertical confinement.

Different materials, configurations and dimensions can be found by computer modelling and/or routine experiment. For example, this may comprise testing whether a polarization is retained (e.g. about 50% or about 80% of its original value) after a given period of time, e.g. after 100 or 200 ms.

### Third memory device - layout

Referring again to Figures 1, 1a and 1b, in the first memory device 1, the isolated gate 7 is arranged as a substantially planar, laterally-extended structure.

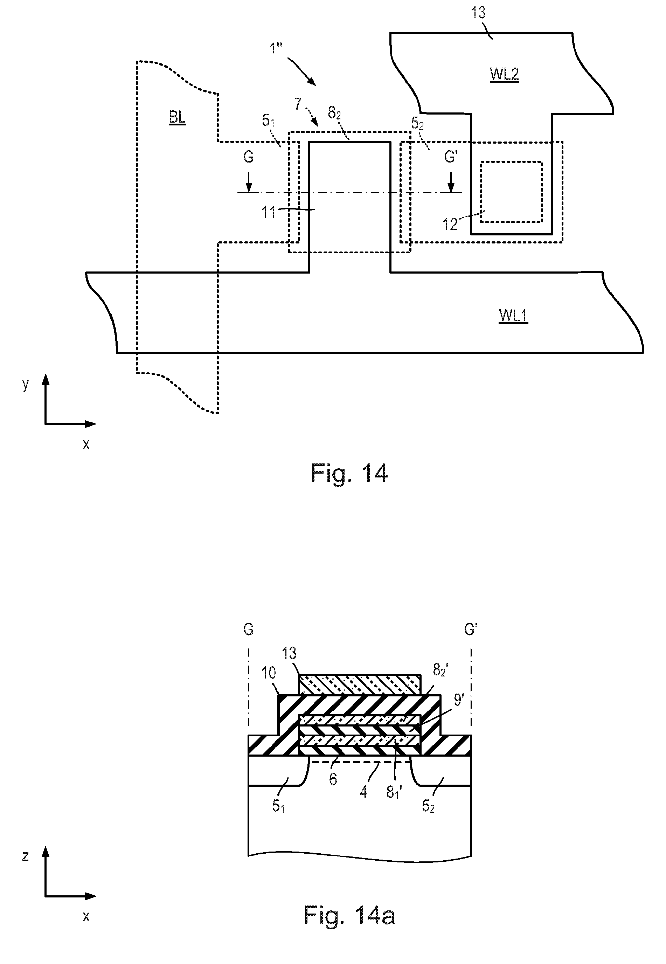

Referring to Figures 14 and 14a, a third memory device 1" in accordance with the present invention is shown.

The third memory device 1" is similar in some respects to first memory device 1 (Figure 1) and like parts are denoted by like reference numerals.

In the third memory device 1", the isolated gate 7' takes the form of a stacked, multilayered structure. The isolated gate 7' comprises a first conductive region 8₁', a barrier region 9' and a second conductive region 8₂'. The first conductive region 8₁' is formed on the gate dielectric 6.

The first and second conductive regions 8₁', 8₂' may each comprise silicon and the barrier region 9' may comprise silicon dioxide, silicon nitride or other dielectric material. More than one barrier region 9' may be used.

The device is fabricated in substantially same way as the first memory device (Figure 1) except that two additional deposition steps are included so as to form a multilayer structure of conductive material, dielectric material and conductive material. The layers can be etched to form a pillar-like structure which can then be used as a self-aligned mask for the contact region implantation.

The vertical device has the advantage the axis of polarization is vertical and can result in higher polarization.

The third memory device 1" is operated in the same or at least in a similar way to the first memory device 1 (Figure 1) described earlier. Therefore, operation of the third memory device 1' is not repeated here.

### Modifications

It will be appreciated that many modifications may be made to the embodiments hereinbefore described.

In some embodiments, one or both of the conductive regions may comprise a metal or metal alloy instead of a semiconductor. One or both of the conductive regions may comprise conductive particles, e.g. nanometre-sized particles (<1 µm), embedded in an insulating matrix.

The conductive regions may be dimensioned to exhibit quantum effects. For example, if the conductive regions or undepleted regions within the conductive regions have a dimension less than the Fermi wavelength of carriers within the conductive regions, then quantum effects may be exhibited.

In some example, two or more barrier regions may be used to form a multiple barrier structure.

The bit and word lines can be differently configured. For example, the first word line can be configured to run as a bit line.

## Claims

1. A memory device comprising:
a semiconductor channel (4);
a control gate (11); and
an isolated gate (7) comprising first and second portions (8₁, 8₂) separated by a barrier region (9), the first gate portion arranged proximate to the channel to control conductivity of the channel and the second portion arranged proximate to the control electrode, the isolated gate comprising non-ferroelectric material;
wherein the isolated gate is configured to be polarizable in response to an applied external electric field generated using the control gate, without injection of charge carriers to or from the channel, and to remain polarized for a given non-zero time after the electric field is removed.

2. A memory device according to claim 1, wherein the barrier region (9) is configured to provide a tunnel barrier between the first and second portions of the isolated gate.

3. A memory device according to claim 1 or 2, wherein the barrier region (9) comprises a semiconductor.

4. A memory device according to claim 1 or 2, wherein the barrier region (9) comprises a dielectric.

5. A memory device according to any preceding claim, wherein the first and second portions (8₁, 8₂) of the isolated gate comprise a semiconductor material.

6. A memory device according to any preceding claim, wherein the first and second portions (8₁, 8₂) of the isolated gate comprise silicon.

7. A memory device according to any preceding claim, further comprising:
a gate dielectric (6) interposed between the first portion (8₁) of the isolated gate (7) and the channel (4).

8. A memory device according to claim 7, wherein the gate dielectric (6) comprises silicon dioxide.

9. A memory device according to any preceding claim, wherein the first and second portions (8₁, 8₂) of the isolated gate are spaced apart in a first direction and the first portion of the isolated gate and the channel (4) are spaced apart in a second direction substantially perpendicular to the first direction.

10. A memory device according to any one of claims 1 to 9, wherein the first and second portions (8₁, 8₂) of the isolated gate are spaced apart in a first direction and the channel runs in a direction between first and second contact regions which is substantially perpendicular to the first direction.

11. A memory device according to any one of claims 1 to 9, wherein the first and second portions (8₁, 8₂) of the isolated gate are spaced apart in a first direction and the channel runs in a direction between first and second contact regions which is substantially parallel to the first direction.

12. A memory array comprising:
an array of memory devices (1) according to any one of claims 1 to 11; and
a set of lines (BL, WL1, WL2) for addressing the memory devices.

13. A logic circuit comprising:
at least one memory device according to any one of claims 1 to 11.

14. A logic circuit according to claim 13, which is a CMOS logic circuit.

15. A method of operating a memory device according to any one of claims 1 to 11, the method comprising:
polarizing the isolated gate at a given time;
reading the memory device; and
polarizing the isolated gate within 500 ms of the given time.
